# EUROPEAN PATENT SPECIFICATION

(11) **EP 0 827 153 B1**
(45) Date of publication and mention of the grant of the patent: **06.11.2002**
(21) Application number: 97306010.6
(22) Date of filing: 07.08.1997
(51) Int. Cl.: G11C 11/22

(54) **Method of writing data to a single transistor type ferroelectric memory cell**
Datenschreibverfahren in einer ferroelektrischen Speicherzelle vom Ein-Transistor-Typ
Méthode d'écriture de données dans une cellule de mémoire ferroélectrique de type à transistor singulier

(30) Priority: 20.08.1996 JP 21821596
(43) Date of publication of application: 04.03.1998
(73) Proprietor: TOKYO INSTITUTE OF TECHNOLOGY, Tokyo (JP)
(72) Inventor: Ishihara, Hiroshi, Ohta-Ku, Tokyo (JP); Tokumitsu, Eisuke, Setagaya-Ku, Tokyo (JP)
(74) Representative: Blatchford, William Michael

(56) References cited:
- US-A- 3 002 182
- US-A- 4 571 585
- US-A- 5 515 311

## Description

The present invention relates to a method of writing data to a single transistor type ferroelectric memory.

Known non-volatile memories which use a ferroelectric material generally have a two element per cell construction with a normal MOS transistor and a ferroelectric capacitor per cell. With such memories, however, there is the drawback that when reading stored information, the information (data) is destroyed (destruction reading). Moreover, in contrast to the EEPROM which uses two transistors of a normal MOSFET and a floating gate type FET per cell, the known flash memory is a single transistor type non-volatile memory which uses one floating gate type FET per cell. However, in cases where a floating gate type FET is used, writing of data cannot be accomplished during the normal operation time of the computer, and with the flash memory, erasure for each cell, that is to say for each bit, is not possible.

Although the flash memory has the above drawback, since there is one element per cell, area effectivity is good. Japanese Patent Publication No. JP 606 8288 (Self Learning Type Sum of Products Operation Circuit Element and Circuit) also discloses a single transistor type non-volatile memory, in this case a single transistor type ferroelectric memory which is described later in detail. The essential difference between this memory and the former is that instead of the requirement for erasing information prior to writing at the floating gate type FET of each cell of the flash memory, with the ferroelectric type FET the erasing operation is not necessary. That is to say, the saturation phenomenon in the polarization of a ferroelectric film is used, giving the advantage that problems do not arise as with the floating gate type FET, where an excessive charge is injected to the floating gate and an excessive charge is extracted.

The single transistor type ferroelectric memory differs from DRAM, or the capacitance type FRAM (ferroelectric RAM) currently under investigation, in that the capacitance is ferroelectric memory there is an advantage of high densification, since via-holes for interconnections are not necessary. Consequently, in addition to the non-volatility characteristics, this memory is expected to find favour as a future high integration low power consumption device.

The above single transistor type ferroelectric memory has a three layer construction in which a ferroelectric film is sandwiched with single-crystal semiconductor stripes and stripe-like conducting electrodes placed approximately perpendicular to the (bottom) semiconductor stripes. When a writing voltage is applied from a peripheral circuit to a selected cell of the memory, the influence of the writing voltage also extends to the other cells along the upper and lower stripes, presenting the problem of a large mutual interference such that the stored data in the non-selected cells are inverted during writing.

It is an aim of the present invention to provide a method of writing data to a single transistor type ferroelectric memory having the advantages of non-volatility, high integration ability, and low power consumption, which method can suppress inter-cell writing interference.

According to the invention, there is provided a method of writing data to a memory device having a matrix of storage cells formed by a plurality of pnp or npn semiconductor structures arranged in columns to form column electrodes at a first level, a plurality of conductors arranged as row electrodes at a second level, and a ferroelectric film at an intermediate level between the semiconductor structures and the row electrodes such that field-effect transistors are formed where the row electrode overlie the semiconductor structures, each storage cell comprising one such transistor, characterised in that the method comprises writing data to a selected cell by: in a first step, applying respective voltages to the row electrode and the column electrode which are those of the selected cell, the voltages being such as to produce at the selected cell a potential difference of a magnitude V and of a predetermined sign between the first level and the second level, and simultaneously applying to the other row and column electrodes further respective voltages such as to produce at the other cells along the selected row and column electrodes a potential difference of a magnitude in the region of a V/3 and of the said predetermined sign and at the cells which are not along the selected row and column electrodes a potential difference of a magnitude in the region of V/3 but of the sign opposite to the said predetermined sign, and in a second step, immediately following the first step, applying to the selected row and column electrodes respective voltages such as to produce at the selected cell a potential difference of a magnitude in the region of V/3 and of the said opposite sign, and simultaneously applying to the other row and column electrodes further respective voltages such as to produce at the other cells along the selected row and column electrodes a potential difference in the region of zero and at the cells which are not along the selected row and column electrodes a potential difference of a magnitude in the region of V/3 and of the said predetermined sign.

The invention will now be described by way of example with reference to the drawings in which:-
Figures 1A and 1B are, respectively, a cross-section and a diagrammatic plan view of the structure of a single transistor type ferroelectric memory to which the method of the present invention may be applied;
Figures 2A and 2B are diagrams for explaining first and second procedures, respectively, of a method in accordance with the invention;
Figure 3 is a graph illustrating polarization changes of a ferroelectric thin film (SrBi₂Ta₂O₉) for various pulse application methods;
Figure 4 is a graph illustrating the polarization/voltage hysteresis characteristic of the ferroelectric thin film (SrBi₂Ta₂O₉) used in Figure 3; and
Figure 5 is a diagram showing an equivalent circuit for the single transistor type ferroelectric memory to which the method to be described below is applied.

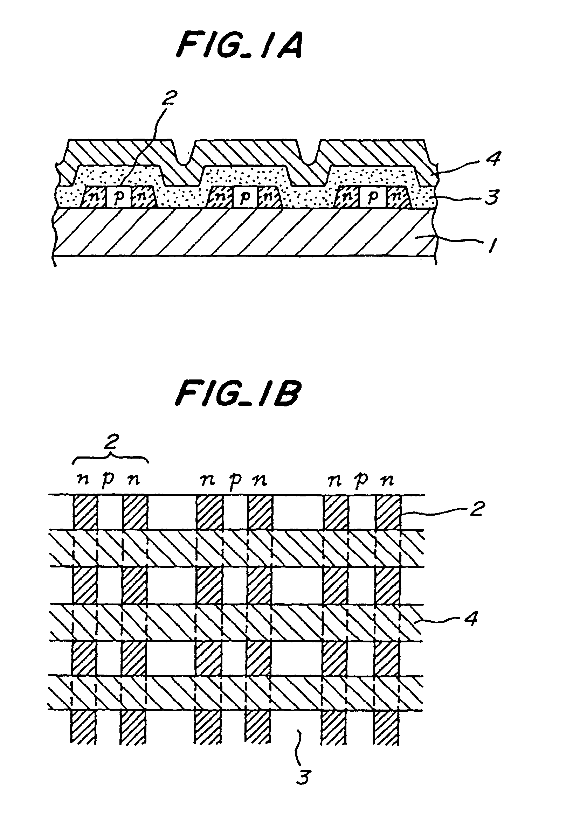

Throughout Figures 1 to 5, the reference numeral 1 indicates an insulator substrate, 2 a plurality of mutually parallel stripe-like single-crystal semiconductor thin film elements electrodes a potential difference of a magnitude in the region of V/3 but of the sign opposite to the said predetermined sign, and in a second step, applying to the selected row and column electrodes respective voltages such as to produce at the selected cell a potential difference of a magnitude in the region of V/3 and of the said opposite sign, and simultaneously applying to the other row and column electrodes further respective voltages such as to produce at the other cells along the selected row and column electrodes a potential difference in the region of zero and at the cells which are not along the selected row and column electrodes a potential difference of a magnitude in the region of V/3 and of the said predetermined sign.

The invention will now be described by way of example with reference to the drawings in which:-
Figures 1A and 1B are, respectively, a cross-section and a diagrammatic plan view of the structure of a single transistor type ferroelectric memory to which the method of the present invention may be applied;

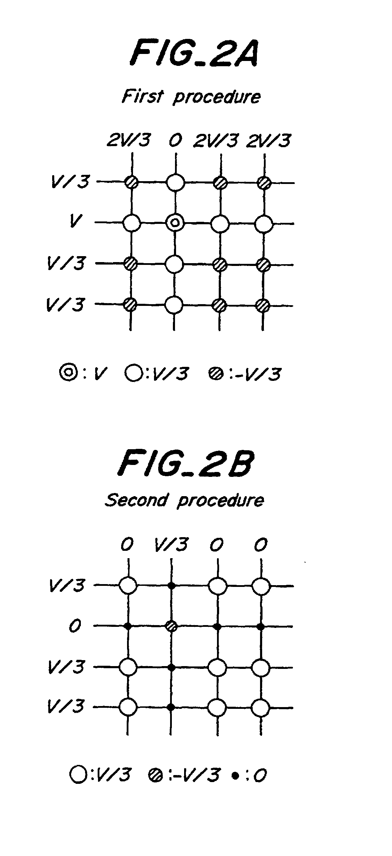

Figures 2A and 2B are diagrams for explaining first and second procedures, respectively, of a method in accordance with the invention;

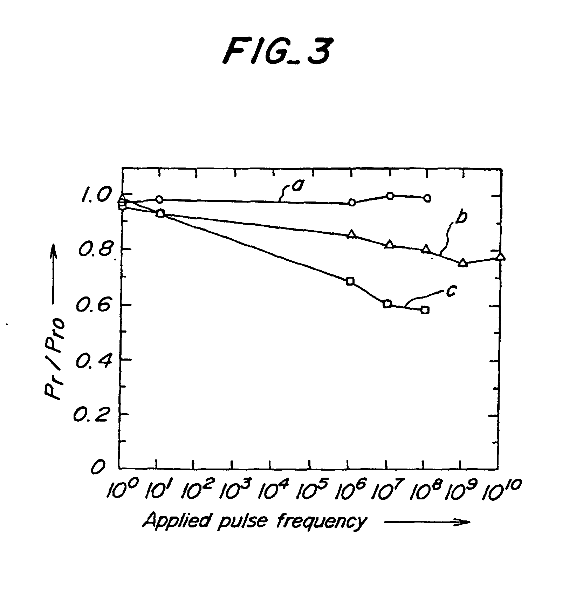

Figure 3 is a graph illustrating polarization changes of a ferroelectric thin film (SrBi₂Ta₂O₉) for various pulse application methods;

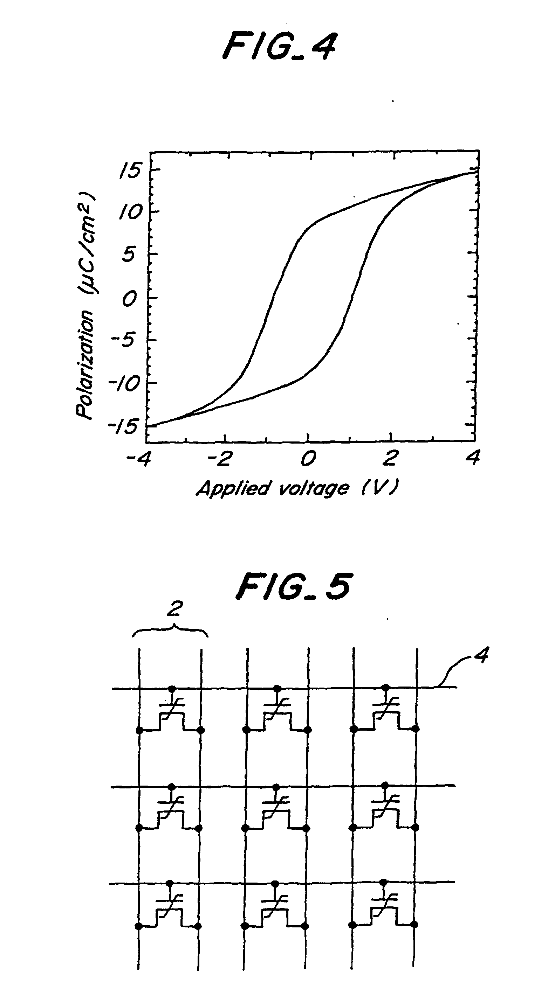

Figure 4 is a graph illustrating the polarization/voltage hysteresis characteristic of the ferroelectric thin film (SrBi₂Ta₂O₉) used in Figure 3; and
Figure 5 is a diagram showing an equivalent circuit for the single transistor type ferroelectric memory to which the method to be described below is applied.

Throughout Figures 1 to 5, the reference numeral 1 indicates an insulator substrate, 2 a plurality of mutually parallel stripe-like single-crystal semiconductor thin film elements with npn or pnp regions, 3 a ferroelectric thin film, and 4 a plurality of mutually parallel stripe-like conducting electrodes.

Referring to Figures 1A and 1B, a single transistor type ferroelectric memory has a plurality of single crystal semiconductor thin film elements 2 having an npn sequence structure in the transverse direction. Elements 2 are formed in columns on an insulator substrate 1 as, for example, a silicon single-crystal thin film in a mutually parallel strip formation. A ferroelectric thin film 3 is deposited on top of these thin film elements 2 so as to cover at least the semiconductor stripe structure. Furthermore, a plurality of mutually parallel stripe-like conducting electrodes 4 (for example metal strips) are deposited on top of the above structure in a direction at least approximately perpendicular to the semiconductor film elements 2. Transistors are formed at the intersections of the semiconductor elements 2 and the conducting electrodes 4, the n regions on both sides forming the source and the drain regions, and the intermediate p regions forming the channels of the transistors. Moreover, the transistors in each column formed by the elements 2 are all connected in parallel (as shown in Figure 5) due to the source and the drain regions being connected as semiconductor stripes. Each such transistor forms a cell of the memory.

The above-described component is referred to as a single transistor type ferroelectric memory and is known, for example, from Japanese Patent Publication No. 7-31705 (Self Learning Type Sum of Products Operation Circuit Element and Circuit). In the structure of this component, a field effect transistor is formed with the ferroelectric thin film 3 as a gate insulator. If a positive voltage is applied, for example, to a word line, i.e. to one of the stripe-like conducting electrodes 4 forming the upper layer, and a negative voltage is applied to a stripe-like silicon element 2 or, alternatively, voltages are applied in accordance with the first procedure of claim 1 below, then a large potential difference can be applied solely to the ferroelectric thin film located at the point of intersection. Hence selective writing of data becomes possible. This is because even though the potential difference to the ferroelectric thin film is removed, a charge corresponding to the remanent polarization remains on the semiconductor surface, and hence the data are retained in a written condition.

If, in the selective writing, a positive voltage V applied to the conducting row electrode 4 is made to correspond to data 1, and an opposite polarity is made to correspond to data 0, then digital data writing becomes possible. Moreover, in reading the data, the conducting row electrode 4 on top of the ferroelectric thin film corresponding to the selected cell of the memory is made the gate electrode, a voltage which is relatively low compared to voltage V is applied to this gate electrode, and a voltage is applied from the peripheral circuit between the source and drain of the underlying npn semiconductor element 2. If the drain current flowing at this time is then read from the peripheral circuit, data of 0 or 1 depending on the magnitude thereof can be read. In order to carry out such a reading operation, the transistor structure and the polarization of the ferroelectric film may be adjusted so that at the time of writing 0, the threshold voltage for the transistor becomes sufficiently high, while at the time of writing 1, this becomes sufficiently low.

Next is a description of a first procedure and an immediately following second procedure, with reference to Figures 2A and 2B, for effectively controlling inter-cell interference when writing to the ferroelectric memory described above.

A first example of writing to a non-volatile memory in accordance with the method of the present invention is based on the following procedure. A voltage V is applied to a selected word line 4 while voltages V/3 are applied to the non-selected word lines 4. Moreover a voltage 0 is applied to a selected silicon element 2, while voltages 2V/3 are applied to the non-selected silicon elements 2. As a result, as shown in Figure 2(a), a potential difference of V occurs only across the gate insulator (ferroelectric layer) of the selected cell, while potential differences of + or -V/3 occur across the gate insulators of all the other cells. Selective polarization control thus becomes possible due to this difference. Since with the writing of the information, the threshold voltage of the FET changes, a gate voltage suitable for reading can be applied to detect the presence of a drain current, and information once written is not lost at the time of reading. The above covers the first procedure.

If immediately after carrying out the writing by applying the voltages as shown in Figure 2A, voltages as shown in Figure 2B are applied, then for the cells which were not selected, voltages of +V/3 are applied to the cells which were subjected to the voltages of -V/3 at the time of writing. As a result, the inter-cell mutual interference during writing can be significantly reduced. The above covers the second procedure.

What should be noted here is that for non-selected cells in the same line or the same column as the selected cell, in the first procedure voltages of V/3 are applied, for example, in the row direction, and in the second procedure voltages of zero are applied, and hence there is not complete cancellation. Likewise, in the column direction, in the second procedure voltages of zero are applied relative to the V/3 voltages of the first procedure and hence, again, there is not complete cancellation. However, the number of relevant cells in the case where the total cell number is for example 500 x 500, is of low probability at approximately 1/250 of the total cell number. Furthermore, as will become apparent from the experimental results referred to below, the significant mutual interference occurs only when a number of interference voltage pulses of -V/3 are successively applied to the ferroelectric film after writing with a voltage of V. Therefore, considering that the memory carries out a random access operation, then overall this is not a problem.

In the above-mentioned example, writing is performed with a positive voltage V. However, a negative voltage -V can also be used. In this case, all the signs for the voltages applied in the first procedure and in the second procedure are reversed.

Experimental clarification that the inter-cell mutual interference at the time of writing can be greatly reduced by means of the first procedure and the second procedure is illustrated by Figure 3. Figure 3 represents measurements of polarization change of a ferroelectric thin film after effecting writing by application of a +V pulse to an experimental sample, described below, equivalent to one cell of the ferroelectric memory. In Figure 3, the horizontal axis shows the number of applied pulses while the vertical axis shows the amount of change in the polarization charge (Pr/Pro; where Pro is the initial value). The sample used here was an MFM (metal/ferroelectric/film /film metal) capacitor described hereafter. Plot a in Figure 3 is for the case where a positive interference pulse (+V/3) only is applied, plot b is for the case where a positive pulse (+V/3) and a negative pulse (-V/3) are applied alternately, while plot c is for the case where a negative pulse (-V/3) only is applied. With the writing method described above with reference to Figures 2A and 2B, the great majority of the cells corresponded to the experimental results of Figure 3 plot b. Accordingly, these experimental results show that, if the above-described writing method is used, then if the ferroelectric gate insulator of a selected cell is written with information, and if this cell is not subsequently selected, then even after carrying out 10¹⁰ writing operations to the other cells, approximately 80% of the polarization of the selected cell is maintained. Considering that discrimination between 0 and 1 of the written data becomes impossible when the vertical axis value in Figure 3 becomes 50%, it can be concluded that the present method of writing effectively suppresses inter-cell interference at the time of writing.

An approximately 250nm thick SrBi₂Ta₂O₉ film was deposited on a Pt/Ti/SiO₂/Si substrate using the sol-gel method. The substrate was silicon crystal bulk with SiO₂ formed thereon, and platinum on titanium electrodes on top of this as lower electrodes. Platinum electrodes of 200µm diameter were used as top electrodes, the ferroelectric coating of SrBi₂Ta₂O₉ being subjected, both before and after forming the upper platinum electrodes, to a heat treatment of 750°C for 30 minutes. Figure 4 shows the characteristic of the ferroelectric hysteresis curve for the film. The experimental pulse V applied to the sample was 1.5 volt. Consequently, V/3 was 0.5 volts and the pulse width was 3µs.

The invention has been described above in relation to one embodiment but is not limited to this embodiment, and it will be apparent that various modifications and changes are possible within the scope of the claims. For example, while above-described embodiment has a silicon single crystal thin film as the single crystal semiconductor thin film, single crystal thin films of other semiconductors such as GaAs and InSb may also be used. Moreover, for the ferroelectric film, films other than SrBi₂Ta₂O₉ also exhibiting ferroelectric characteristics may be used.

As will be clear from the above description, application of the above methods of writing data to a single transistor type ferroelectric memory allows inter-cell interference at the time of writing to be effectively suppressed, offering a high quality non-volatile memory with high integration and low power consumption.

## Claims

1. A method of writing data to a memory device having a matrix of storage cells formed by a plurality of pnp or npn semiconductor structures arranged in columns to form column electrodes at a first level, a plurality of conductors arranged as row electrodes at a second level, and a ferroelectric film at an intermediate level between the semiconductor structures and the row electrodes such that field-effect transistors are formed where the row electrodes overlie the semiconductor structures, each storage cell comprising one such transistor, **characterised in that** the method comprises writing data to a selected cell by:
in a first step, applying respective voltages to the row electrode and the column electrode which are those of the selected cell, the voltages being such as to produce at the selected cell a potential difference of a magnitude V and of a predetermined sign between the first level and the second level, and simultaneously applying to the other row and column electrodes further respective voltages such as to produce at the other cells along the selected row and column electrodes a potential difference of a magnitude in the region of a V/3 and of the said predetermined sign and at the cells which are not along the selected row and column electrodes a potential difference of a magnitude in the region of V/3 but of the sign opposite to the said predetermined sign, and
in a second step, immediately after the first step, applying to the selected row and column electrodes respective voltages such as to produce at the selected cell a potential difference of a magnitude in the region of V/3 and of the said opposite sign, and simultaneously applying to the other row and column electrodes further respective voltages such as to produce at the other cells along the selected row and column electrodes a potential difference in the region of zero and at the cells which are not along the selected row and column electrodes a potential difference of a magnitude in the region of V/3 and of the said predetermined sign.

2. A method according to claim 1, **characterised in that** pnp or npn semiconductor structures are formed in a silicon crystal or in silicon thin film stripes provided on an insulator substrate.

3. A method according to claim 1 or claim 2, **characterised in that** said plurality of conductors arranged as the row electrodes are metal electrodes.

4. A method according to any preceding claim, **characterised in that** in the first step the voltages applied to the selected row and column electrodes are respectively of magnitude V and zero while those applied to the other row and column electrodes are respectively of magnitude V/3 and 2V/3 and of the same sign as that applied to the selected row electrode, and **in that** in the second step the voltages applied to the selected row and column electrodes are respectively of magnitude zero and V/3, while those applied to the other row and column electrodes are respectively V/3 and zero, the sign of the voltages applied to the selected column electrode and those applied to the said other row electrodes being the same as the sign of the voltage applied to the selected row electrode in the first step.

5. A method according to any preceding claim, **characterised in that**, in writing a plurality of data bits of logic level "1" and logic level "0" to the memory device, the sign of the potential difference applied at each selected cell during the said first step of any one writing operation is either positive if the respective data bit to be written is of one of the logic levels or negative if the data bit is of the other of the logic levels.

## Patentansprüche

1. Verfahren zum Schreiben von Daten in eine Speichereinrichtung, welche eine Matrix von Speicherzellen hat, die durch eine Vielzahl von pnp- oder npn-Halbleiterstrukturen gebildet sind, welche in Spalten angeordnet sind, um Spaltenelektroden in einer ersten Ebene zu bilden, eine Vielzahl von Leitern hat, welche als Zeilenelektroden in einer zweiten Ebene angeordnet sind, und einen ferroelektrischen Film in einer Zwischenebene, zwischen den Halbleiterstrukturen und den Zeilenelektroden aufweist, so dass Feldeffekttransistoren dort gebildet werden, wo die Zeilenelektroden über den Halbleiterstrukturen liegen, wobei jede Speicherzelle einen derartigen Transistor aufweist, **dadurch gekennzeichnet, dass** das Verfahren das Schreiben von Daten in eine ausgewählte Zelle umfasst, indem:
in einem ersten Schritt zugehörige Spannungen an die Zeilenelektrode und die Spaltenelektrode angelegt werden, welche diejenigen der ausgewählten Zelle sind, wobei die Spannungen derart sind, so dass sie bei der ausgewählten Zelle eine Potentialdifferenz der Größe V und mit einem vorbestimmten Vorzeichen zwischen der ersten Ebene und der zweiten Ebene erzeugen, und gleichzeitig an den anderen Zeilen- und Spaltenelektroden weitere zugehörige Spannungen derart angelegt werden, so dass bei den anderen Zellen entlang der ausgewählten Zeilen- und Spaltenelektroden eine Potentialdifferenz der Größe im Bereich von V/3 und dem vorgegebenen Vorzeichen und bei den Zellen, welche nicht entlang der ausgewählten Zeilen- und Spaltenelektroden sind, eine Potentialdifferenz der Größe im Bereich von V/3 aber mit entgegengesetztem Vorzeichen zu dem vorgegebenen Vorzeichen erzeugt wird, und
in einem zweiten Schritt sofort nach dem ersten Schritt an die ausgewählten Zeilen- und Spaltenelektroden jeweils Spannungen derart angelegt werden, so dass sie an der ausgewählten Zelle eine Potentialdifferenz der Größe im Bereich von V/3 und von entgegengesetztem Vorzeichen erzeugen, und gleichzeitig an den anderen Zeilen- und Spaltenelektroden weitere entsprechende Spannungen derart angelegt werden, so dass bei den anderen Zellen entlang der ausgewählten Zeilen- und Spaltenelektroden eine Potentialdifferenz im Bereich von Null und bei den Zellen, welche nicht entlang der ausgewählten Zeilen- und Spaltenelektroden sind, eine Potentialdifferenz der Größe im Bereich von V/3 und des vorgegebenen Vorzeichens erzeugt wird.

2. Verfahren nach Anspruch 1, **dadurch gekennzeichnet, dass** die pnp- oder npn-Strukturen in einem Siliziumkristall oder in dünnen Siliziumfilmstreifen gebildet werden, auf einem Isoliersubstrat vorgesehen sind.

3. Verfahren nach Anspruch 1 oder 2, **dadurch gekennzeichnet, dass** die Vielzahl von als Zeilenelektroden angeordneten Leiter Metallelektroden sind.

4. Verfahren nach einem der vorhergehenden Ansprüche, **dadurch gekennzeichnet, dass** in dem ersten Schritt die an die ausgewählten Zeilen- und Spaltenelektroden angelegten Spannungen jeweils von der Größe V und Null sind, während diejenigen, welche an die anderen Zeilen- und Spaltenelektroden angelegt werden, jeweils von der Größe V/3 und 2 V/3 und vom gleichen Vorzeichen sind, wie diejenigen welche an die ausgewählte Zeilenelektrode angelegt wird, und dass in dem zweiten Schritt die an die ausgewählten Zeilen- und Spaltenelektroden angelegten Spannungen jeweils von der Größe Null und V/3 sind, während diejenigen, welche an die anderen Zeilen- und Spaltenelektroden angelegt werden, jeweils V/3 und Null sind, wobei das Vorzeichen der Spannungen, welche an die ausgewählten Spaltenelektrode angelegt werden und derjenigen, welche an die anderen Zeilenelektroden angelegt werden, das gleiche ist wie das Vorzeichen der Spannung, welche an die ausgewählte Zeilenelektrode im ersten Schritt angelegt wird.

5. Verfahren nach einem der vorhergehenden Ansprüche, **dadurch gekennzeichnet, dass** beim Schreiben einer Vielzahl von Datenbits des logischen Pegels "1" und des logischen Pegels "0" in die Speichereinrichtung das Vorzeichen der Potentialdifferenz, welche an jeder ausgewählten Zelle während des ersten Schrittes einer Schreiboperation angelegt wird, entweder positiv ist, wenn das jeweils zu schreibende Datenbit den einen logischen Pegel hat oder negativ ist, wenn das Datenbit von den anderen logischen Pegel hat.

## Revendications

1. Procédé d'écriture de données dans un dispositif de mémoire comportant une matrice de cellules de stockage constituée par un certain nombre de structures de semi-conducteurs pnp ou npn, disposées en colonnes pour former des électrodes de colonnes à un premier niveau, un certain nombre de conducteurs disposés comme électrodes de rangées à un second niveau, et un film ferroélectrique à un niveau intermédiaire entre les structures de semi-conducteurs et les électrodes de rangées, de façon que des transistors à effet de champ soient formés aux endroits où les électrodes de rangées recouvrent les structures de semi-conducteurs, chaque cellule de stockage comprenant un tel transistor,
**caractérisé en ce que**
le procédé comprend l'écriture de données dans une cellule sélectionnée, par les opérations consistant à :
dans une première étape, appliquer des tensions respectives à l'électrode de rangée et à l'électrode de colonne qui sont celles de la cellule sélectionnée, ces tensions étant telles qu'elles produisent, à l'endroit de la cellule sélectionnée, une différence de potentiel de grandeur V et de signe prédéterminé entre le premier niveau et le second niveau, et appliquer simultanément aux électrodes des autres rangées et des autres colonnes, d'autres tensions respectives permettant de produire, dans les autres cellules le long des électrodes de rangées et de colonnes sélectionnées, une différence de potentiel ayant une grandeur se situant dans la zone de V/3 avec le signe prédéterminé, et dans les autres cellules qui ne sont pas le long des électrodes de rangées et de colonnes sélectionnées, une différence de potentiel ayant une grandeur se situant dans la zone de V/3 mais avec le signe opposé au signe prédéterminé, et
dans une seconde étape, aussitôt après la première étape, appliquer aux électrodes de rangées et de colonnes sélectionnées, des tensions respectives permettant de produire, dans la cellule sélectionnée, une différence de potentiel ayant une grandeur se situant dans la zone de V/3, avec le signe opposé, et appliquer simultanément aux électrodes des autres rangées et des autres colonnes, d'autres tensions respectives permettant de produire, dans les autres cellules, le long des électrodes de rangées et de colonnes sélectionnées, une différence de potentiel se situant dans la zone de zéro, et dans les cellules qui ne sont pas le long des électrodes de rangées et de colonnes sélectionnées, une différence de potentiel ayant une grandeur se situant dans la zone de V/3 avec le signe prédéterminé.

2. Procédé selon la revendication 1,
**caractérisé en ce que**
les structures de semi-conducteurs pnp ou npn sont formées dans un cristal de silicium ou dans des bandes de films minces de silicium prévues sur un substrat isolant.

3. Procédé selon la revendication 1, ou la revendication 2,
**caractérisé en ce que**
la pluralité de conducteurs disposés en électrodes de rangées sont des électrodes métalliques.

4. Procédé selon l'une quelconque des revendications précédentes,
**caractérisé en ce que**
dans la première étape, les tensions appliquées aux électrodes de rangées et de colonnes sélectionnées sont respectivement de grandeur V et de grandeur zéro, tandis que les tensions appliquées aux électrodes des autres rangées et des autres colonnes sont respectivement de grandeurs V/3 et 2 V/3 avec le même signe que celui appliqué à l'électrode de rangée sélectionnée, et
dans la seconde étape, les tensions appliquées aux électrodes de rangées et de colonnes sélectionnées sont respectivement de grandeur zéro et de grandeur V/3, tandis que les tensions appliquées aux électrodes des autres rangées et des autres colonnes sont respectivement de V/3 et zéro, le signe des tensions appliquées à l'électrode de colonne sélectionnée et les signes appliqués aux électrodes des autres rangées, étant les mêmes que le signe de la tension appliquée à l'électrode de rangée sélectionnée dans la première étape.

5. Procédé selon l'une quelconque des revendications précédentes,
**caractérisé en ce que**
dans l'écriture d'un certain nombre de bits de données de niveau logique "1" et de niveau logique "0" dans le dispositif de mémoire, le signe de la différence de potentiel appliquée à chaque cellule sélectionnée dans la première étape d'une opération d'écriture quelconque, est soit positif si le bit de données respectif devant être écrit est de l'un des niveaux logiques, soit négatif si le bit de données est de l'autre des niveaux logiques.
